(19) **Europäisches Patentamt**
**European Patent Office**
**Office européen des brevets**

(11) **EP 2 929 531 B1**

(12) **EUROPEAN PATENT SPECIFICATION**

(45) Date of publication and mention
of the grant of the patent:
**03.03.2021 Bulletin 2021/09**

(51) Int Cl.:
*G10L 19/022* *(2013.01)*        *G10L 25/45* *(2013.01)*
*G10L 19/02* *(2013.01)*

(21) Application number: **13863103.1**

(22) Date of filing: **11.12.2013**

(86) International application number:
**PCT/KR2013/011495**

(87) International publication number:
**WO 2014/092460 (19.06.2014 Gazette 2014/25)**

(54) **METHOD OF ENCODING AND DECODING AUDIO SIGNAL AND APPARATUS FOR ENCODING AND DECODING AUDIO SIGNAL**

VERFAHREN ZUM CODIEREN UND DECODIEREN EINES AUDIOSIGNALS UND VORRICHTUNG ZUM CODIEREN UND DECODIEREN EINES AUDIOSIGNALS

PROCÉDÉ DE CODAGE ET DÉCODAGE DE SIGNAL AUDIO ET APPAREIL POUR CODER ET DÉCODER LE SIGNAL AUDIO

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.12.2012 KR 20120143833**

(43) Date of publication of application:
**14.10.2015 Bulletin 2015/42**

(73) Proprietor: **Samsung Electronics Co., Ltd.**
**Suwon-si, Gyeonggi-do 443-742 (KR)**

(72) Inventors:
• **LEE, Nam-suk**
**Suwon-si**
**Gyeonggi-do 443-706 (KR)**
• **KIM, Hyun-wook**
**Suwon-si**
**Gyeonggi-do 441-885 (KR)**
• **MOON, Han-gil**
**Daejeon 300-752 (KR)**

(74) Representative: **Appleyard Lees IP LLP**
**15 Clare Road**
**Halifax HX1 2HY (GB)**

(56) References cited:
WO-A2-2010/086373        US-A1- 2003 115 052
US-A1- 2003 115 052        US-A1- 2007 016 405
US-A1- 2008 027 719        US-A1- 2008 059 202
US-A1- 2008 065 373        US-A1- 2012 022 881

• **MALVAR H S: "LAPPED TRANSFORMS FOR EFFICIENT TRANSFORM/SUBBAND CODING", IEEE TRANSACTIONS ON ACOUSTICS, SPEECH AND SIGNAL PROCESSING, IEEE INC. NEW YORK, USA, vol. 38, no. 6, 1 June 1990 (1990-06-01), pages 969-978, XP000138423, ISSN: 0096-3518, DOI: 10.1109/29.56057**

## Description

### Technical Field

Exemplary embodiments relate to a method of encoding and decoding an audio signal, and an apparatus for encoding and decoding an audio signal. More particularly, exemplary embodiments relate to a method and apparatus for time-frequency transforming frames of an audio signal by applying a first window, a second window, and a third window to the frames.

### Background Art

Related art apparatuses for encoding audio, having high sound quality, use a time-frequency transform method. The time-frequency transform method of the related art is a method of encoding coefficients, obtained by transforming an input audio signal to a frequency space, using a transform method, such as a modified discrete cosine transform (MDCT).

The time-frequency transform of the related art uses a signal in a frequency domain, which is easier to encode than a signal in a time domain. Since a window shape applied to an audio signal is closely related to a frequency resolution, the window shape should be properly selected.

Patent document US2003115052 A1 discloses a transform coder adaptively configuring window sizes for transform coding in a two-pass process to maximize coding efficiency.

### Disclosure of Invention

### Technical Problem

Exemplary embodiments may provide a method of encoding and decoding an audio signal, and an apparatus for encoding and decoding an audio signal to reduce a delay, occurring due to the encoding and the decoding of the audio signal.

Exemplary embodiments may provide a method of encoding and decoding an audio signal, and an apparatus for encoding and decoding an audio signal, to improve an encoding and decoding efficiency of the audio signal.

### Solution to Problem

According to an aspect of the exemplary embodiments, there is provided a method of encoding an audio signal according to claim 1.

According to another aspect of the exemplary embodiments, there is provided a method of decoding an audio signal according to claim 6.

### Brief Description of Drawings

The above and other features and advantages of the exemplary embodiments will become more apparent by describing in detail exemplary embodiments thereof with reference to the attached drawings in which:

FIG. 1 illustrates a method of applying windows to an audio signal to perform a modified discrete cosine transform (MDCT) on the audio signal in a related art advanced audio coding (AAC) codec;
FIGS. 2A to 2C are diagrams for describing a delay occurring due to encoding and decoding when the related art AAC codec is used;
FIG. 3 is a block diagram of an apparatus for encoding an audio signal, according to an embodiment;
FIGS. 4A to 4C illustrate a first window, a second window, and a third window applied to frames of an audio signal in the apparatus for encoding an audio signal, according to an embodiment;
FIG. 5 illustrates frames of an audio signal to which a first window, a second window, and a third window are applied in the apparatus for encoding an audio signal, according to an embodiment;
FIGS. 6A to 6C are diagrams for describing a delay occurring due to encoding and decoding in the apparatus for encoding an audio signal, according to an embodiment;
FIG. 7 is a flowchart illustrating a method of encoding an audio signal, according to another embodiment;
FIG. 8 is a block diagram of an apparatus for decoding an audio signal, according to another embodiment; and
FIG. 9 is a flowchart illustrating a method of decoding an audio signal, according to another embodiment.
FIG. 10 is a block diagram of a multimedia device according to an exemplary embodiment;
FIG. 11 is a block diagram of a multimedia device according to another exemplary embodiment; and
FIG. 12 is a block diagram of a multimedia device according to another exemplary embodiment.

### Mode for the Invention

Advantages and features of the exemplary embodiments, and a method for achieving them will be clear with reference to the accompanying drawings, in which exemplary embodiments are shown. The exemplary embodiments may, however, be embodied in many different forms and should not be construed as being limited to the embodiments set forth herein. These embodiments are provided so that this disclosure will be thorough and complete, and will fully convey the concept of the exemplary embodiments to one of ordinary skill in the art. Like reference numerals denote like elements throughout the specification.

The term '...unit' used in the embodiments indicates a component including software or hardware, such as a Field Programmable Gate Array (FPGA) or an Application-Specific Integrated Circuit (ASIC), and the '...unit' performs certain roles. However, the '...unit' is not limited to software or hardware. The '...unit' may be configured to be included in an addressable storage medium or to reproduce one or more processors. Therefore, for example, the '...unit' includes components, such as software components, object-oriented software components, class components, and task components, processes, functions, attributes, procedures, subroutines, segments of program code, drivers, firmware, microcode, circuits, data, a database, data structures, tables, arrays, and variables. A function provided inside components and '...units' may be combined into a smaller number of components and '...units', or further divided into additional components and '...units'.

In the specification, the expression "a length of a window or a predetermined duration is a (a is a natural number) samples" indicates "the window or the predetermined duration includes a samples".

In addition, in the specification, "a frame size of a predetermined window" indicates the number of coefficients in a frequency domain, as acquired when frames in a time domain to which the predetermined window is applied are time-frequency transformed.

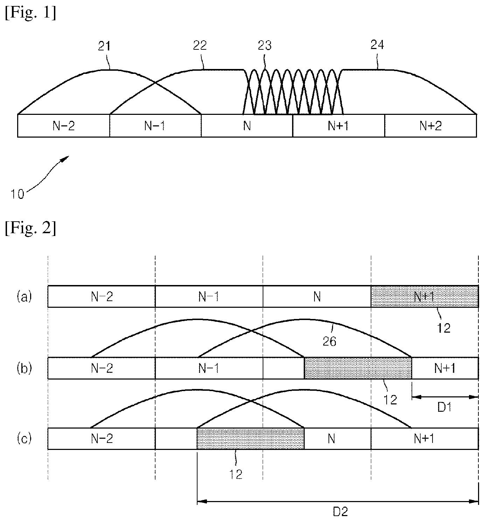

FIG. 1 illustrates a method of applying windows to an audio signal 10 to perform a modified discrete cosine transform (MDCT) on the audio signal 10 in a related art advanced audio coding (AAC) codec.

The related art AAC codec is defined as a window applied to frames N-2, N-1, N, N+1, and N+2 of the audio signal 10. The audio signal 10 includes i) a long window 21, ii) a short window 23, iii) a long start window 22, and iv) a long short window 24.

A length of each of the frames N-2, N-1, N, N+1, and N+2 of the audio signal 10 shown in FIG. 1 is 1024 samples. A length of each of the long window 21, the long start window 22, and the long short window 24 is 2048 samples. A length of the short window 23 is 256 samples.

When n samples, to which a window is applied, are time-frequency transformed, n/2 coefficients are acquired. Thus, a frame size of each of the long window 21, the long start window 22, and the long short window 24 is 1024, and a frame size of the short window 23 is 128.

The long window 21, the long start window 22, the long short window 24, and the short window 23 overlap one other by 50%.

The audio signal 10 may be distinguished in transform units, wherein the "transform unit" indicates a duration in which a same number of coefficients can be acquired, when the time-frequency transform is performed, by applying a window.

Since the longest window of windows defined by the AAC codec is the long window 21, the long start window 22, or the long short window 24, one long window 21, one long start window 22, or one long short window 24 may be applied to one transform unit. In other words, a length of a transform unit for the long window 21, the long start window 22, or the long short window 24 is 2048 samples.

When it is desired to apply the short window 23 to one transform unit, a total of 8 short windows 23 ($8 \times 128 = 1024$) are applied to the transform unit so that the number of coefficients is 1024. Since the 8 short windows 23 overlap one other by 50%, a length of the transform unit, to which the 8 short windows 23 are applied, is less than 2048 samples. In other words, a length of a transform unit may vary, according to a type of a window applied to the transform unit.

The related art AAC codec applies the short window 23 to a signal quickly varying in the time domain, i.e., a transient signal, to increase a frequency resolution, and applies the long window 21 to a signal slowly varying in the time domain, to prevent the waste of a frequency band. The long start window 22 is applied to frames to overlap a first short window 23 when a short window set starts, and the long short window 24 is applied to frames to overlap a last short window 23 when the short window set ends.

According to the related art AAC codec, since a delay due to the 50% overlapping between every two windows and a delay due to window switching to the long start window 22 or the long short window 24 occur, there is a problem that coding efficiency is deteriorated.

In addition, since the related art AAC codec applies 8 short windows 23 to the entire transform unit even, when a transient signal exists in only a partial duration of the transform unit, there is also a problem that coding efficiency is deteriorated.

FIGS. 2A to 2C are diagrams for describing a delay occurring due to encoding and decoding when the related art AAC codec is used.

FIG. 2A illustrates an audio signal input to an encoder, FIG. 2B illustrates a time-frequency transform performed by the encoder, and FIG. 2C illustrates a time-frequency detransform performed by a decoder.

In the related art AAC codec, a window 26 to be applied to a current frame 12 is determined as a long window or a long start window, according to whether a window to be applied to a next frame is a short window. In other words, referring to FIG. 2B, the encoder determines the window 26 to be applied to the current frame 12 to time-frequency transform the current frame 12, and the determination of the window 26 is performed after a predetermined number of samples included in the next frame are analyzed by the encoder. The predetermined samples are look-ahead samples for window switching. Thus, encoding is delayed by the look-ahead samples.

Referring to FIGS. 1 and 2A to 2C, since a length of a short window set to be applied to the next frame of the current frame 12 is 576 samples ($128 \times 4 + 128 \div 2$), at least 576 look-ahead samples are required to determine the window 26 to be applied to the current frame 12. An encoding delay D1 occurs due to the look-ahead samples.

The decoder should wait for the next frame overlapping the current frame 12 to time-frequency detransform the current frame 12. Since every two windows overlap one other by 50% in the MDCT, 1024 samples that are 50% of 2048 samples overlap the current frame 12. Thus, a delay occurs due to an overlapping duration in the decoder.

In addition, when the current frame 12 is a first frame of the audio signal, the decoder requires a delay of 1024 samples to process the current frame 12.

In conclusion, a delay D2 due to encoding and decoding in the related art AAC codec includes the delay D1 due to the look-ahead samples, a delay due to the overlapping duration, and the delay due to the current frame 12. Therefore, when a sampling rate is 48 KHz, a total delay due to the related art AAC codec is 54.7 ms.

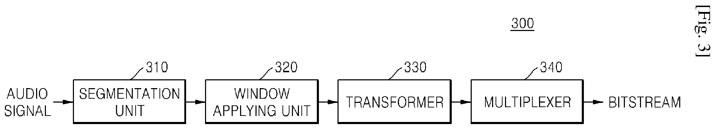

FIG. 3 is a block diagram of an apparatus 300 for encoding an audio signal, according to an embodiment.

Referring to FIG. 3, the apparatus 300 may include a segmentation unit 310, a window applying unit 320, a transformer 330, and a multiplexer 340. The segmentation unit 310, the window applying unit 320, the transformer 330, and the multiplexer 340 may be formed by a microprocessor.

The segmentation unit 310 may receive an audio signal and segment the received audio signal into frames each including M (M is a natural number greater than 1) samples. The segmentation unit 310 may receive the audio signal from a memory unit (not shown) included in the apparatus 300, or an external device.

The window applying unit 320 applies a first window, a second window, and at least one third window to the frames of the audio signal. The second window may be longer than a length of the first window, and the third window may have a length between the length of the first window and the length of the second window. The window applying unit 320 may apply at least one first window, at least one second window, or at least one third window to one transform unit. In the specification, in comparison with the related art AAC codec, it is assumed that the length of the first window is 256 samples, and the length of the second window is 2048 samples. However, the lengths of the first window and the second window may be variously set in a range that is obvious to one of ordinary skill in the art.

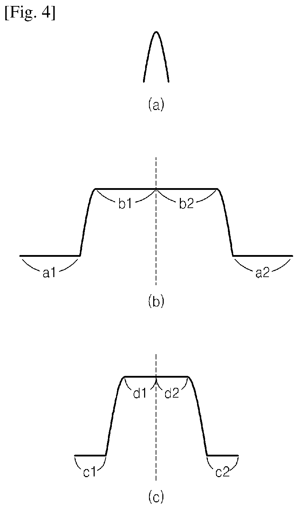

The first window, the second window, and the third window will be described below in detail, with reference to FIG. 4.

The transformer 330 time-frequency transforms the frames to which the first window, the second window, and the third window are applied. The time-frequency transform, according to the exemplary embodiments, may include any one of discrete cosine transform (DCT), modified discrete cosine transform (MDCT), and fast Fourier transform (FFT).

The multiplexer 340 generates and outputs a bitstream, including the time-frequency transformed frames.

Although not shown in FIG. 3, the apparatus 300 may further include a quantizer for quantizing coefficients in the frequency domain, which are generated by the transformer 330, and a bit allocator for allocating bits to the quantized coefficients.

FIGS. 4A to 4C illustrate the first window, the second window, and the third window, applied to frames of an audio signal in the apparatus 300 for encoding an audio signal, according to an embodiment.

FIGS. 4A, 4B, and 4C illustrate the first window, the second window, and the third window, respectively.

As described above, the length of the first window may be 256 samples, and the length of the second window may be 2048 samples. The length of the third window is longer than the length of the first window, and shorter than the length of the second window. The third window may have various lengths, according to characteristics of audio signals.

Referring to FIG. 4B, the second window, according to the exemplary embodiments, may include first and second zero durations a1 and a2 of which a coefficient is 0 (zero), and first and second unity durations b1 and b2 of which a coefficient is 1. In addition, referring to FIG. 4C, like the second window, the third window may also include first and second zero durations c1 and c2 and first and second unity durations d1 and d2. On the contrary, the first window shown in FIG. 4A may not include zero durations and unity durations.

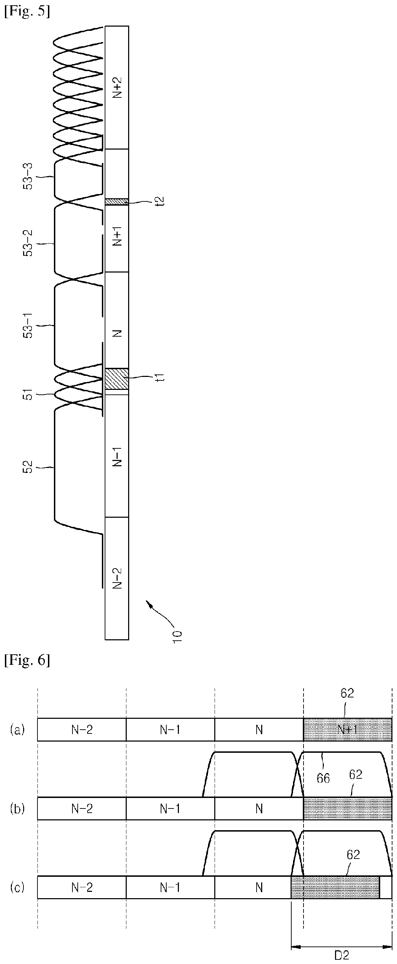

FIG. 5 illustrates frames of an audio signal 10 to which a first window 51, a second window 52, and a third window 53 are applied in the apparatus 300 for encoding the audio signal 10, according to an embodiment.

First, the window applying unit 320 may apply the first window 51, the second window 52, and the third window 53 to the frames, except for durations of which a coefficient is 0 (zero) so that overlapping duration lengths between every two windows are all the same.

In the related art AAC codec, an overlapping duration length between a long window and another long window differs from an overlapping duration length between a short window and another short window. Accordingly, a long start window and a long short window are required to connect a long window and a short window. However, since overlapping duration lengths between every two of the first windows 51, the second windows 52, and the third windows 53 are all the same according to the exemplary embodiments, neither long start windows nor long short windows are required. In addition, each of the overlapping duration lengths between every two of the first windows 51, the second windows 52, and the third windows 53 may be set to 1/2 of the length of the first window 51. In other words, each overlapping duration length may be 128 samples. According to the exemplary embodiments, since overlapping duration lengths between every two windows are much less than those in the related art AAC codec, a delay due to window overlapping is reduced.

As described above, while coding efficiency is deteriorated by applying 8 short windows to the entire transform unit in the related art AAC codec when a transient signal duration exists in part of a duration of one transform unit, referring to FIG. 5, the window applying unit 320 may apply at least one first window 51 only to a transient signal duration t1, from which a transient signal is detected. In addition, in the duration remaining by excluding the transient signal duration t1 from the transform unit, the window applying unit 320 may apply at least one third window 53-1, of which a length has been properly adjusted to the transform unit, so that the at least one third window 53-1 overlaps the at least one first window 51.

Although not shown in FIG. 3, the apparatus 300 may further include an analyzer for analyzing characteristics of an audio signal. The analyzer may determine whether a transient duration exists in a current frame, by calculating a similarity or mean energy difference between frames of the audio signal. The analyzer does not have to be separately included, when the apparatus 300 has a function of determining a transient duration. For example, when the apparatus 300 has a wave coder or a parametric coder, such as AAC, MP3, etc., functioning to determine a transient duration, the corresponding function may be used.

A method of properly selecting a length of a third window will now be described.

When a first window of the windows according to the related art AAC codec is applied to one transform unit, 8 first windows are required.

However, since the window applying unit 320 applies the first window 51 only to the duration t1 in which a transient signal exists, the number of first windows 51 may be 6 or less.

When 6 first windows 51 are applied, since a sum of frame sizes of the 6 first windows 51 is 768 (128×6), a frame size of the third window 53-1 is 256, and a length of the third window 53-1 is 512 samples. Since the third window 53-1 is applied next to two first windows 51 in FIG. 5, a length of the third window 53-1 is 1536 samples.

In addition, the window applying unit 320 may apply one first window 51 and one third window 53, or two third windows 53-2 and 53-3, overlapping each other in a variation duration t2, to a transform unit including the variation duration t2, in which characteristics of the audio signal vary. The characteristics of the audio signal may include various characteristics, such as a frequency, tone, intensity, etc., by which the audio signal can be evaluated. A variation duration may include a transient signal duration. If a length of a variation duration, in which characteristics of an audio signal variance is very short, only two windows may overlap each other, to improve coding efficiency. A length of each of the two third windows 53-2 and 53-3 shown in FIG. 5 may be set in the method described above. In other words, when a length of any one of the two third windows 53-2 and 53-3 is determined, a length of the other of the two third windows 53-2 and 53-3 may be determined, such that a sum of frame sizes of the two third windows 53-2 and 53-3 is the same as a frame size of the second window 52.

Referring back to FIG. 3, the window applying unit 320 may determine a form of the third window to satisfy a perfect construction condition of the time-frequency transform.

Under the Princen-Bradley condition, a window applied to a frame should satisfy Equation 1 below:
MathFigure 1

[Math.1]

$$w^2(n) + w^2(n+M) = 1$$

In Equation 1, w denotes a window function, n denotes a sample index, and M denotes a frame length.

In addition, to satisfy Equation 1 above, a length of a first zero duration, a second zero duration, a first unity duration, and a second unity duration of the window should satisfy Equation 2 below:
MathFigure 2

[Math.2]

$$(F-L) / 2$$

In Equation 2, F denotes a frame size of a window, and L denotes an overlapping duration length.

Since the overlapping duration length is 128 samples, a length of a first zero duration, a second zero duration, a first unity duration, and a second unity duration of a second window is 448 samples ((1024-128)/2).

Table 1 below shows lengths R of a first zero duration, a second zero duration, a first unity duration, and a second unity duration according to frame sizes of windows:

Table 1

[Table 1]

| F | R |
|---|---|
| 1024 (128 x 8) | 448 |
| 896 (128 x 7) | 384 |
| 768 (128 x 6) | 320 |
| 640 (128 x 5) | 256 |
| 512 (128 x 4) | 192 |
| 384 (128 x 3) | 128 |
| 256 (128 x 2) | 64 |

(continued)

| F | R |
|---|---|
| 128 (128 x 1) | 0 |

In Table 1, a window of which a frame size is 896 indicates a third window to be applied to a transform unit by overlapping a single first window, when the single first window is applied to the transform unit.

According to the exemplary embodiments, M, a length of a first window, a length of a second window, and a length of a third window may be set to $2^k$. Accordingly, a computation amount required for encoding and decoding may be reduced.

The window applying unit 320 may generate information regarding windows applied to the frames of the audio signal, and transmits the generated information to the multiplexer 340. The multiplexer 340 may generate and output a bitstream, including the time-frequency transformed frames and the information regarding the windows.

FIGS. 6A to 6C are diagrams for describing a delay occurring due to encoding and decoding in the apparatus 300 for encoding an audio signal, according to an embodiment.

FIG. 6A illustrates an audio signal input to an encoder, FIG. 6B illustrates a time-frequency transform performed by the encoder, and FIG. 6C illustrates a time-frequency detransform performed by a decoder.

As described above, in the related art AAC codec, an encoder requires look-ahead samples to determine the window 26 to be applied to the current frame 12. However, according to the exemplary embodiments, since the first windows, the second windows, and the third windows have the same overlapping duration lengths, no look-ahead samples are required to determine a window 66 to be applied to a current frame 62. Thus, in the encoding shown in FIG. 6A, a delay due to look-ahead samples does not occur.

The decoder, according to the exemplary embodiments, also should wait for a next frame overlapping the current frame 62. Since each of overlapping duration lengths between every two of the first windows, the second windows, and the third windows is 128 samples, an overlapping delay of 128 samples occurs in the decoder according to the exemplary embodiments, which is significantly less than a delay of 1024 samples, occurring in the related art AAC codec.

In addition, when the current frame 62 is a first frame of the audio signal, the decoder according to the exemplary embodiments requires a delay of 1024 samples, to process the current frame 62, as in the related art AAC codec.

In conclusion, a delay D2 due to the encoding and the decoding, according to the exemplary embodiments, includes a delay due to an overlapping duration and a delay due to the current frame 62. When a sampling rate is 48 KHz, a total delay is 24 ms.

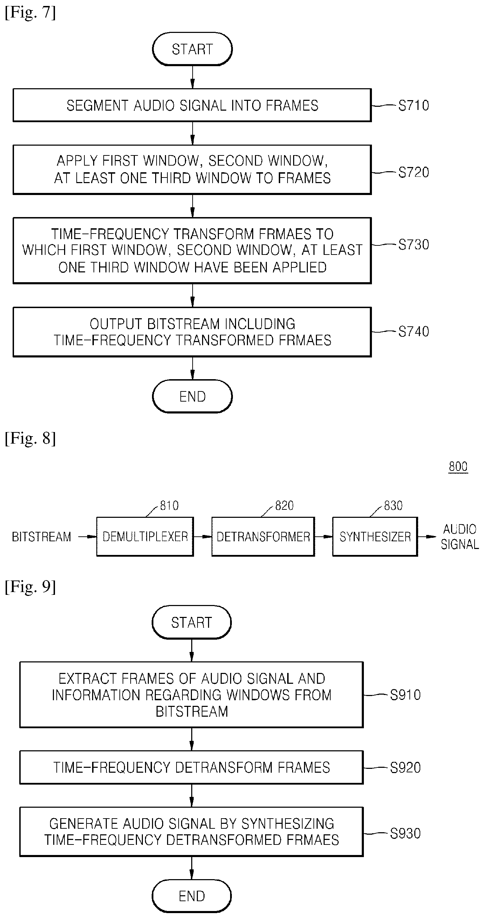

FIG. 7 is a flowchart illustrating a method of encoding an audio signal, according to another embodiment. Referring to FIG. 7, the method includes operations processed by the apparatus 300 shown in FIG. 3. Thus, although omitted hereinafter, the above description related to the apparatus 300 shown in FIG. 3 also applies to the method of FIG. 7.

In operation S710, the apparatus 300 segments an input audio signal into frames. Each of the frames may include M (M is a natural number greater than 1) samples.

In operation S720, the apparatus 300 applies a first window, a second window, and at least one third window to the frames. A length of the first window is shortest, a length of the second window is longest, and a length of the third window is between the length of the first window and the length of the second window.

In operation S730, the apparatus 300 time-frequency transforms the frames to which the first window, the second window, and the at least one third window have been applied. The time-frequency transform may include any one of DCT, MDCT, and FFT.

In operation S740, the apparatus 300 outputs a bitstream, including the time-frequency transformed frames. The bitstream may further include information regarding the windows applied to the frames, wherein the information regarding the windows may include type or length information of the windows applied to the frames.

FIG. 8 is a block diagram of an apparatus 800 for decoding an audio signal, according to another embodiment.

Referring to FIG. 8, the apparatus 800 may include a demultiplexer 810, a detransformer 820, and a synthesizer 830. The demultiplexer 810, the detransformer 820, and the synthesizer 830 may be formed by a microprocessor.

The demultiplexer 810 may extract frames of a time-frequency transformed audio signal and information regarding windows applied to the frames, from a bitstream. The bitstream may be received from an external encoding apparatus 300.

The detransformer 820 time-frequency detransforms the frames of the time-frequency transformed audio signal. The detransformer 820 may time-frequency detransform the frames in a method corresponding to the time-frequency transform method performed by the apparatus 300.

The synthesizer 830 may generate an audio signal by synthesizing the time-frequency detransformed frames based on the information regarding the windows, which has been extracted from the bitstream. In detail, the synthesizer 830 may generate the audio signal by applying the same windows as those used in the apparatus 300 to the time-frequency detransformed frames, based on the information regarding the windows, which has been extracted from the bitstream, and synthesizing the frames to which the windows have been applied. In addition, the synthesizer 830 may apply at least one first window, at least one second window, and at least one third window to one transform unit.

The information regarding the windows, which is included in the bitstream, may include information regarding the first window, the second window, and the third window, wherein a length of the first window may be shortest, a length of the second window may be longest, and a length of the third window may be between the length of the first window and the length of the second window.

Since the first window, the second window, and the third window have been described above in relation to the apparatus 300, a detailed description thereof is omitted.

Although not shown in FIG. 8, the apparatus 800 may further include a dequantizer and an inverse bit allocator, to correspond to the apparatus 300.

FIG. 9 is a flowchart illustrating a method of decoding an audio signal, according to another embodiment.

Referring to FIG. 9, in operation S910, the apparatus 800 extracts frames of a time-frequency transformed audio signal and information regarding windows applied to the frames, from a bitstream. The information regarding the windows may include form and length information of the windows, applied to the frames.

In operation S920, the apparatus 800 time-frequency detransforms the time-frequency transformed frames. The apparatus 800 may perform a detransform, corresponding to the time-frequency transform method performed by the apparatus 300.

In operation S930, the apparatus 800 generates an audio signal by synthesizing the time-frequency detransformed frames, based on the information regarding the windows.

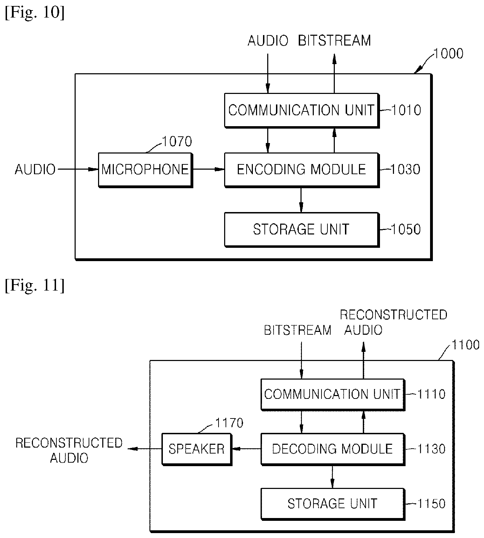

FIG. 10 is a block diagram of a multimedia device including an encoding module 1030, according to an exemplary embodiment.

The multimedia device 1000 shown in FIG. 10 may include a communication unit 1010 and the encoding module 1030. In addition, the multimedia device 1000 may further include a storage unit 1050 for storing an audio bitstream, which is obtained as an encoded result, according to the usage of the audio bitstream. In addition, the multimedia device 1000 may further include a microphone 1070. That is, the storage unit 1050 and the microphone 1070 are optional. In addition, the multimedia device 1000 may further include an arbitrary decoding module (not shown), e.g., a decoding module for performing a general decoding function or a decoding module according to an exemplary embodiment. The encoding module 1030 may be combined with other components (not shown) included in the multimedia device 1000 in a one body and implemented as at least one processor (not shown).

Referring to FIG. 10, the communication unit 1010 may receive at least one of audio and an encoded bitstream provided from the outside or transmit at least one of reconstructed audio and an audio bitstream obtained as an encoded result.

The communication unit 1010 may be configured to transmit and receive data to and from an external multimedia device via a wireless network, such as wireless Internet, wireless Intranet, a wireless telephone network, a wireless local area network (WLAN), Wi-Fi, Wi-Fi Direct (WFD), third generation (3G), fourth generation (4G), Bluetooth, infrared data association (IrDA), radio frequency identification (RFID), ultra wideband (UWB), Zigbee, or near field communication (NFC), or a wired network, such as a wired telephone network or wired Internet.

According to an exemplary embodiment, the encoding module 1030 may be implemented by an apparatus of FIG. 3.

The storage unit 1050 may store the encoded bitstream generated by the encoding module 1030. In addition, the storage unit 1050 may store various programs required to operate the multimedia device 1000.

The microphone 1070 may provide an audio signal of a user or the outside to the encoding module 1030.

FIG. 11 is a block diagram of a multimedia device including a decoding module, according to another exemplary embodiment.

The multimedia device 1100 shown in FIG. 11 may include a communication unit 1110 and the decoding module 1130. In addition, the multimedia device 1100 may further include a storage unit 1150 for storing a reconstructed audio signal, which is obtained as a decoding result, according to the usage of the reconstructed audio signal. In addition, the multimedia device 1100 may further include a speaker 1170. That is, the storage unit 1150 and the speaker 1170 are optional. In addition, the multimedia device 1100 may further include an arbitrary encoding module (not shown), e.g., an encoding module for performing a general encoding function or an encoding module according to an exemplary embodiment. The decoding module 1130 may be combined with other components (not shown) included in the multimedia device 1100 in a one body and implemented as at least one processor (not shown).

Referring to FIG. 11, the communication unit 1110 may receive at least one of an encoded bitstream and an audio signal provided from the outside or may transmit at least one of reconstructed audio and an audio bitstream obtained as a decoded result. The communication unit 1110 may be implemented to be substantially similar to the communication unit 1010 of FIG. 10.

According to an embodiment of the present invention, the decoding module 1130 may be implemented by an apparatus of FIG. 8.

The storage unit 1150 may store a restored audio signal generated by the decoding module 1130. In addition, the storage unit 1150 may store various programs required to operate the multimedia device 1100.

The speaker 1170 may output the reconstructed audio signal generated by the decoding module 1130 to the outside.

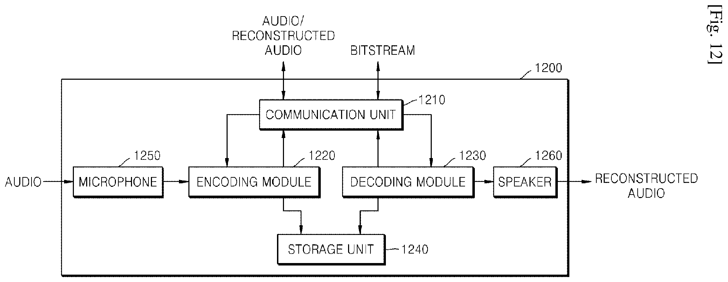

FIG. 12 is a block diagram of a multimedia device including an encoding module and a decoding module, according to another exemplary embodiment.

The multimedia device 1200 shown in FIG. 12 may include a communication unit 1210, the encoding module 1220, and the decoding module 1230. In addition, the multimedia device 1200 may further include a storage unit 1240 for storing an audio bitstream or a restored audio signal, which is obtained as an encoded result or a decoded result, according to the usage of the audio bitstream or the reconstructed audio signal. In addition, the multimedia device 1200 may further include a microphone 1250 or a speaker 1260. The encoding module 1220 or the decoding module 1230 may be combined with other components (not shown) included in the multimedia device 1200 in a one body and implemented as at least one processor (not shown).

Since the components shown in FIG. 12 are the same as the components of the multimedia device 1000 shown in FIG. 10 or the components of the multimedia device 1100 shown in FIG. 11, a detailed description thereof is omitted.

Each of the multimedia devices 1000, 1100, and 1200 may further include a voice communication dedicated terminal including a telephone, a mobile phone, and so forth, a broadcast or music dedicated device including a TV, an MP3 player, and so forth, or a complex terminal device of the voice communication dedicated terminal and the broadcast or music dedicated device but is not limited thereto. In addition, each of the multimedia devices 1000, 1100, and 1200 may be used as a client, a server, or a conversion device disposed between a client and a server.

When the multimedia device 1000, 1100, or 1200 is, for example, a mobile phone, although not shown, the mobile phone may further include a user input unit, such as a keypad, a user interface or a display unit for displaying information processed by the mobile phone, and a processor for controlling a general function of the mobile phone. In addition, the mobile phone may further include a camera unit having an image capturing function and at least one component for performing a function required by the mobile phone.

When the multimedia device 1000, 1100, or 1200 is, for example, a TV, although not shown, the TV may further include a user input unit, such as a keypad, a display unit for displaying received broadcast information, and a processor for controlling a general function of the TV. In addition, the TV may further include at least one component for performing a function required for the TV.

The embodiments can be written as computer programs, and can be implemented in general-use digital computers that execute the programs using a computer-readable recording medium. Examples of the computer-readable recording medium include storage media, such as magnetic storage media (e.g., ROM, floppy disks, hard disks, etc.), optical recording media (e.g., CD-ROMs, or DVDs), and carrier waves (e.g., transmission through the Internet).

While the exemplary embodiments have been particularly shown and described with reference to exemplary embodiments thereof, it will be understood by those of ordinary skill in the art that various changes in form and details may be made therein without changing the essential features of the exemplary embodiments. Therefore, the embodiments described above should be understood as not limitations, but illustrations of the exemplary embodiments.

**Claims**

1. A method of encoding an audio signal, the method comprising:

segmenting the audio signal into a plurality of frames, wherein each of the frames includes M samples and M is a natural number greater than one (S710);
applying a first window (51), a second window (52), and at least one third window (53) to the frames, wherein:

a first window (51) and at least one third window (53-1) are applied, in case of a first transient signal duration, t1, whereby the first window and the at least one third window overlap in the first transient signal duration, t1, wherein a length of the second window is longer than a length of the first window, and a length of the at least one third window is longer than the length of the first window and shorter than the length of the second window(S720); and
two third windows (53-2, 53-3) are applied, in case of a second transient signal duration, t2, shorter than the first transient signal duration, t1, whereby the two third windows overlap in the second transient signal duration, t2, and wherein a sum of lengths of the two third windows is the same as a length of the second window (52),
time-frequency transforming the frames to which the first window, the second window, and the at least one third window have been applied(S730); and

generating a bitstream including the time-frequency transformed frames(S740); and wherein each of the second window and the at least one third window includes a first zero duration and a second zero duration, in which a coefficient is zero, and a unity duration, in which a coefficient is one, and a length of the first zero duration, the second zero duration, and the unity duration is determined to satisfy a perfect reconstruction condition.

2. The method of claim 1, wherein the first window, the second window, and the at least one third window have a same overlapping duration length where the first window, the second window, and the at least one third window overlap each other, except for durations in which a coefficient is zero.

3. The method of claim 1, wherein the length of the first zero duration, the second zero duration, and the unity duration is determined as $(F - L) \div 2$, where F denotes a frame size of a corresponding window, and L denotes an overlapping duration length between windows.

4. The method of claim 1, wherein M is $2^k$, and a length of the first window, the second window, and the at least one third window is $2^k$ samples.

5. The method of claim 1, wherein the bitstream includes information regarding applied windows to the frames of the audio signal.

6. A method of decoding an audio signal, the method comprising:

extracting a plurality of frames of a time-frequency transformed audio signal and information regarding applied windows to the frames, from a bitstream(S910);
time-frequency detransforming the extracted frames(S920); and
generating an audio signal by synthesizing the time-frequency detransformed frames based on the information regarding the applied windows(S930),
wherein the applied windows to the frames include a first window, a second window, and at least one third window, wherein
a first window (51) and at least one third window (53-1) are applied, in case of a first transient signal duration, t1, whereby the first window and the at least one third window overlap in the first transient signal duration, t1, wherein a length of the second window is longer than a length of the first window, and a length of the at least one third window is longer than the length of the first window and shorter than the length of the second window(S720); and
two third windows (53-2, 53-3) are applied, in case of a second transient signal duration, t2, shorter than the first transient signal duration, t1, whereby the two third windows overlap in the second transient signal duration, t2, and wherein a sum of lengths of the two third windows is the same as a length of the second window (52), wherein each of the second window and the at least one third window includes a first zero duration and a second zero duration, in which a coefficient is zero, and a unity duration, in which a coefficient is one, and a length of the first zero duration, the second zero duration, and the unity duration is determined to satisfy a perfect reconstruction condition.

7. The method of claim 6, wherein the first window, the second window, and the third window have a same overlapping duration length where the first window, the second window, and the at least one third window overlap each other, except for durations in which a coefficient is zero.

8. The method of claim 6, wherein the length of the first zero duration, the second zero duration, the unity duration is determined as $(F - L) \div 2$, where F denotes a frame size of a corresponding window, and L denotes an overlapping duration length between windows.

**Patentansprüche**

1. Verfahren zum Codieren eines Audiosignals, wobei das Verfahren Folgendes umfasst:

Segmentieren des Audiosignals in mehrere Frames, wobei jeder der Frames M Abtastwerte enthält und M eine natürliche Zahl größer als eins ist (S710);
Anwenden eines ersten Fensters (51), eines zweiten Fensters (52) und mindestens eines dritten Fensters (53) auf die Frames, wobei:

ein erstes Fenster (51) und mindestens ein drittes Fenster (53-1) angewendet werden, im Falle einer ersten transienten Signaldauer t1, wobei sich das erste Fenster und das mindestens ein dritte Fenster in der ersten transienten Signaldauer t1 überlappen, wobei eine Länge des zweiten Fensters länger als eine Länge des ersten Fensters ist und eine Länge des mindestens einen dritten Fensters länger als die Länge des ersten Fensters und kürzer als die Länge des zweiten Fensters ist (S720); und
zwei dritte Fenster (53-2, 53-3) angewendet werden, im Falle einer zweiten transienten Signaldauer t2 kürzer als die erste transiente Signaldauer t1, wobei sich die zwei dritten Fenster in der zweiten transienten Signaldauer t2 überlappen, und wobei eine Summe der Längen der zwei dritten Fenster gleich einer Länge des zweiten Fensters (52) ist,

Zeit-Frequenz-Transformieren der Frames, auf die das erste Fenster, das zweite Fenster und das mindestens ein dritte Fenster angewendet wurden (S730); und

Erzeugen eines Bitstroms einschließlich der Zeit-Frequenz-transformierten Frames (S740); und wobei jedes des zweiten Fensters und des mindestens einen dritten Fensters eine erste Nulldauer und eine zweite Nulldauer, in der ein Koeffizient Null ist, und eine Einheitsdauer, in der ein Koeffizient Eins ist, enthält, und eine Länge der ersten Nulldauer, der zweiten Nulldauer und der Einheitsdauer bestimmt wird, um eine perfekte Rekonstruktionsbedingung zu erfüllen.

2. Verfahren nach Anspruch 1, wobei das erste Fenster, das zweite Fenster und das mindestens ein drittes Fenster eine gleiche überlappende Dauer haben, wobei sich das erste Fenster, das zweite Fenster und das mindestens eine dritte Fenster überlappen, mit Ausnahme von Dauer, in der ein Koeffizient Null ist.

3. Verfahren nach Anspruch 1, wobei die Länge der ersten Nulldauer, der zweiten Nulldauer und der Einheitsdauer als (F - L) ÷ 2 bestimmt wird, wobei F eine Frame-Größe eines entsprechenden Fensters bezeichnet und L eine überlappende Dauer zwischen Fenstern bezeichnet.

4. Verfahren nach Anspruch 1, wobei M $2^k$ ist und eine Länge des ersten Fensters, des zweiten Fensters und des mindestens einen dritten Fensters $2^k$ Abtastwerte beträgt.

5. Verfahren nach Anspruch 1, wobei der Bitstrom Informationen bezüglich angewendeten Fenster auf die Frames des Audiosignals enthält.

6. Verfahren zum Decodieren eines Audiosignals, wobei das Verfahren Folgendes umfasst:

Extrahieren mehrerer Frames eines Zeit-Frequenz-transformierten Audiosignals und von Informationen bezüglich der an die Frames angewendeten Fenster aus einem Bitstrom (S910); Zeit-Frequenz-Transformieren der extrahierten Frames (S920); und Erzeugen eines Audiosignals durch Synthetisieren der Zeit-Frequenz-transformierten Frames basierend auf den Informationen bezüglich der angewendeten Fenster (S930), wobei die auf die Frames angewendeten Fenster ein erstes Fenster, ein zweites Fenster und mindestens ein drittes Fenster umfassen, wobei ein erstes Fenster (51) und mindestens ein drittes Fenster (53-1) angewendet werden, im Falle einer ersten transienten Signaldauer t1, wobei sich das erste Fenster und das mindestens ein dritte Fenster in der ersten transienten Signaldauer t1 überlappen, wobei eine Länge des zweiten Fensters länger als eine Länge des ersten Fensters ist, und eine Länge des mindestens einen dritten Fensters länger als die Länge des ersten Fensters und kürzer als die Länge des zweiten Fensters (S720) ist; und zwei dritte Fenster (53-2, 53-3) angewendet werden, wenn eine zweite transiente Signaldauer t2 kürzer als die erste transiente Signaldauer t1 ist, wobei sich die zwei dritten Fenster in der zweiten transienten Signaldauer t2 überlappen, und wobei eine Summe der Längen der zwei dritten Fenster gleich einer Länge des zweiten Fensters (52) ist, wobei jedes des zweiten Fensters und des mindestens einen dritten Fensters eine erste Nulldauer und eine zweite Nulldauer enthält, in denen ein Koeffizient Null ist, und eine Einheitsdauer, in der ein Koeffizient Eins ist, und eine Länge der ersten Nulldauer, der zweiten Nulldauer und der Einheitsdauer bestimmt wird, um eine perfekte Rekonstruktionsbedingung zu erfüllen.

7. Verfahren nach Anspruch 6, wobei das erste Fenster, das zweite Fenster und das dritte Fenster die gleiche überlappende Dauer haben, wobei sich das erste Fenster, das zweite Fenster und das mindestens eine dritte Fenster überlappen, mit Ausnahme von Dauer, in der ein Koeffizient Null ist.

8. Verfahren nach Anspruch 6, wobei die Länge der ersten Nulldauer, der zweiten Nulldauer, der Einheitsdauer als (F - L) ÷ 2 bestimmt wird, wobei F eine Frame-Größe eines entsprechenden Fensters und L eine überlappende Dauer zwischen den Fenstern bezeichnet.

**Revendications**

1. Procédé de codage d'un signal audio, le procédé comprenant :

la segmentation du signal audio en une pluralité de trames, dans lequel chacune des trames comporte M échantillons et M est un entier naturel supérieur à un (S710); l'application d'une première fenêtre (51), d'une deuxième fenêtre (52) et d'au moins une troisième fenêtre (53) aux trames, dans lequel :

une première fenêtre (51) et au moins une troisième fenêtre (53-1) sont appliquées, en cas d'une première durée de signal transitoire, t1, moyennant quoi la première fenêtre et l'au moins une troisième fenêtre se chevauchent dans la première durée de signal transitoire, t1, dans lequel une longueur de la deuxième fenêtre est plus grande qu'une longueur de la première fenêtre, et une longueur de l'au moins une troisième fenêtre est plus grande que la longueur de la première fenêtre et plus petite que la longueur de la deuxième fenêtre(S720) ; et deux troisièmes fenêtres (53-2, 53-3) sont appliquées, en cas d'une seconde durée de signal transitoire, t2, plus petite que la première durée de signal transitoire, t1, moyennant quoi les deux troisièmes fenêtres se chevauchent dans la seconde durée de signal transitoire, t2, et dans lequel une somme de longueurs des deux troisièmes fenêtres est la même qu'une longueur de la deuxième fenêtre (52),

la transformation temps-fréquence des trames auxquelles la première fenêtre, la deuxième fenêtre et l'au moins une troisième fenêtre ont été appliquées(S730) ; et

la génération d'un train de bits comportant les trames à transformation temps-fréquence(S740) ; et dans lequel chacune de la deuxième fenêtre et de l'au moins une troisième fenêtre comporte une première durée nulle et une seconde durée nulle, dans lesquelles un coefficient est égal à zéro, et une durée unitaire, dans laquelle un coefficient est égal à un, et une longueur de la première durée nulle, la seconde durée nulle et la durée unitaire est déterminée pour satisfaire à une condition de reconstitution parfaite.

2. Procédé selon la revendication 1, dans lequel la première fenêtre, la deuxième fenêtre et l'au moins une troisième fenêtre ont une même longueur de durée de chevauchement où la première fenêtre, la deuxième fenêtre et l'au moins une troisième fenêtre se chevauchent mutuellement, excepté en ce qui concerne les durées dans lesquelles un coefficient est égal à zéro.

3. Procédé selon la revendication 1, dans lequel la longueur de la première durée nulle, la seconde durée nulle et la durée unitaire est déterminée en tant que (F - L) ÷ 2, où F désigne une taille de trame d'une fenêtre correspondante, et L désigne une longueur de durée de chevauchement entre des fenêtres.

4. Procédé selon la revendication 1, dans lequel M est égal à 2$^k$, et une longueur de la première fenêtre, de la deuxième fenêtre et de l'au moins une troisième fenêtre correspond à des échantillons 2$^k$.

5. Procédé selon la revendication 1, dans lequel le train de bits comporte des informations concernant les fenêtres appliquées aux trames du signal audio.

6. Procédé de décodage d'un signal audio, le procédé comprenant :

l'extraction d'une pluralité de trames d'un signal audio à transformation temps-fréquence et d'informations concernant des fenêtres appliquées aux trames, d'un train de bits (S910);
la détransformation temps-fréquence des trames extraites(S920) ; et
la génération d'un signal audio en synthétisant les trames à détransformation temps-fréquence sur la base des informations concernant les fenêtres appliquées(S930),
dans lequel les fenêtres appliquées aux trames comportent une première fenêtre, une deuxième fenêtre et au moins une troisième fenêtre, dans lequel
une première fenêtre (51) et au moins une troisième fenêtre (53-1) sont appliquées, en cas d'une première durée de signal transitoire, t1, moyennant quoi la première fenêtre et l'au moins une troisième fenêtre se chevauchent dans la première durée de signal transitoire, t1, dans lequel une longueur de la deuxième fenêtre est plus grande qu'une longueur de la première fenêtre, et une longueur de l'au moins une troisième fenêtre est plus grande que la longueur de la première fenêtre et plus petite que la longueur de la deuxième fenêtre(S720) ; et deux troisièmes fenêtres (53-2, 53-3) sont appliquées, en cas d'une seconde durée de signal transitoire, t2, plus petite que la première durée de signal transitoire, t1, moyennant quoi les deux troisièmes fenêtres se chevauchent dans la seconde durée de signal transitoire, t2, et dans lequel une somme de longueurs des deux troisièmes fenêtres est la même qu'une longueur de la deuxième fenêtre (52),
dans lequel chacune de la deuxième fenêtre et de l'au moins une troisième fenêtre comporte une première durée nulle et une seconde durée nulle, dans lesquelles un coefficient est égal à zéro, et une durée unitaire, dans laquelle un coefficient est égal à un, et une longueur de la première durée nulle, la seconde durée nulle et la durée unitaire est déterminée pour satisfaire à une condition de reconstitution parfaite.

**7.** Procédé selon la revendication 6, dans lequel la première fenêtre, la deuxième fenêtre et la troisième fenêtre ont une même longueur de durée de chevauchement où la première fenêtre, la deuxième fenêtre et l'au moins une troisième fenêtre se chevauchent mutuellement, excepté en ce qui concerne les durées dans lesquelles un coefficient est égal à zéro.

**8.** Procédé selon la revendication 6, dans lequel la longueur de la première durée nulle, la seconde durée nulle et la durée unitaire est déterminée en tant que (F - L) ÷ 2,
où F désigne une taille de trame d'une fenêtre correspondante, et L désigne une longueur de durée de chevauchement entre des fenêtres.

[Fig. 1]

[Fig. 2]

[Fig. 3]

[Fig. 4]

(a)

(b)

(c)

[Fig. 5]

[Fig. 6]

[Fig. 7]

```
                    ┌─────────┐
                    │  START  │
                    └────┬────┘
                         │
         ┌───────────────▼────────────────┐
         │  SEGMENT AUDIO SIGNAL INTO      │──── S710
         │           FRAMES               │
         └───────────────┬────────────────┘
                         │
         ┌───────────────▼────────────────┐
         │  APPLY FIRST WINDOW, SECOND     │
         │  WINDOW, AT LEAST ONE THIRD     │──── S720
         │  WINDOW TO FRAMES              │
         └───────────────┬────────────────┘
                         │
         ┌───────────────▼────────────────┐
         │  TIME-FREQUENCY TRANSFORM       │
         │  FRMAES TO WHICH FIRST WINDOW,  │──── S730
         │  SECOND WINDOW, AT LEAST ONE    │
         │  THIRD WINDOW HAVE BEEN APPLIED │
         └───────────────┬────────────────┘
                         │
         ┌───────────────▼────────────────┐
         │  OUTPUT BITSTREAM INCLUDING     │──── S740
         │  TIME-FREQUENCY TRANSFORMED     │
         │  FRMAES                        │
         └───────────────┬────────────────┘
                         │
                    ┌────▼────┐
                    │   END   │
                    └─────────┘
```

[Fig. 8]

800

```
              ┌810            ┌820            ┌830
          ┌──────────────┐ ┌──────────────┐ ┌─────────────┐
BITSTREAM →│ DEMULTIPLEXER │→│ DETRANSFORMER │→│ SYNTHESIZER │→ AUDIO
          └──────────────┘ └──────────────┘ └─────────────┘   SIGNAL
```

[Fig. 9]

```
                    ┌─────────┐
                    │  START  │
                    └────┬────┘
                         │
         ┌───────────────▼────────────────┐
         │  EXTRACT FRAMES OF AUDIO SIGNAL │
         │  AND INFORMATION REGARDING      │──── S910
         │  WINDOWS FROM BITSTREAM         │
         └───────────────┬────────────────┘
                         │
         ┌───────────────▼────────────────┐
         │  TIME-FREQUENCY DETRANSFORM     │──── S920
         │           FRAMES               │
         └───────────────┬────────────────┘
                         │
         ┌───────────────▼────────────────┐
         │  GENERATE AUDIO SIGNAL BY       │
         │  SYNTHESIZING TIME-FREQUENCY    │──── S930
         │  DETRANSFORMED FRMAES           │
         └───────────────┬────────────────┘
                         │
                    ┌────▼────┐
                    │   END   │
                    └─────────┘
```

[Fig. 10]

AUDIO BITSTREAM

1000

COMMUNICATION UNIT —1010

1070

AUDIO → MICROPHONE → ENCODING MODULE —1030

STORAGE UNIT —1050

[Fig. 11]

RECONSTRUCTED
BITSTREAM   AUDIO

1100

COMMUNICATION UNIT —1110

1170

RECONSTRUCTED ← SPEAKER ← DECODING MODULE —1130
AUDIO

STORAGE UNIT —1150

[Fig. 12]

**REFERENCES CITED IN THE DESCRIPTION**

**Patent documents cited in the description**

- US 2003115052 A1